# EUROPEAN PATENT SPECIFICATION

(11) **EP 0 564 348 B1**
(45) Date of publication and mention of the grant of the patent: **01.03.2000**
(21) Application number: 93400809.5
(22) Date of filing: 29.03.1993
(51) Int. Cl.: G03F 1/14

(54) **Frame-supported pellicle**
Rahmen-gestützte Membrane
Opercule pelliculaire supporté par un châssis

(30) Priority: 01.04.1992 JP 10849992
(43) Date of publication of application: 06.10.1993
(73) Proprietor: SHIN-ETSU CHEMICAL CO., LTD., Chiyoda-ku Tokyo (JP)
(72) Inventor: Kashida, Meguru, Annaka-shi, Gunma-ken (JP); Kubota, Yoshihiro, Takasaki-shi, Gunma-ken (JP); Hamada, Yuichi, Annaka-shi, Gunma-ken (JP)
(74) Representative: Armengaud Ainé, Alain

(56) References cited:
- EP-A- 0 378 420
- EP-A- 0 438 602
- EP-A- 0 469 928
- US-A- 4 171 397
- US-A- 5 073 422

## Description

### BACKGROUND OF THE INVENTION

The present invention relates to a frame-supported pellicle used for dust-proof protection of a photomask in the photolithographic patterning process for the manufacture of various kinds of electronic devices such as LSIs, VLSIs, liquid-crystal display units and the like by mounting on the photomask. More particularly, the invention relates to a method for temporarily protecting a pellicle frame coated, on the surface opposite to the surface to which a pellicle membrane is attached by adhesive bonding, with an organopolysiloxane-based pressure-sensitive adhesive composition to facilitate mounting thereof on a photomask.

It is a well established technology in the manufacture of various kinds of electronic devices such as LSIs, VLSIs, liquid-crystal display units that a process of photolithographic patterning is undertaken to form a pattern on a substrate such as a semiconductor silicon wafer, base plate for a liquid-crystal display unit, in which the surface of the substrate is exposed pattern-wise to ultraviolet light through a pattern-bearing transparency as a photomask. When dust particles are deposited on the photomask, great drawbacks are caused in the fidelity or quality of the pattern reproduction due to scattering of the light by the dust particles. Accordingly, it is usual that the patterning work is conducted in a special clean room but no clean room can be perfectly dust-free so that a conventional measure undertaken is that a frame-supported pellicle membrane, which is a very thin transparent film of a polymeric material, is mounted on the photomask to protect the photomask surface from deposition of any dust particles.

The above mentioned frame-supported pellicle has a structure in which a thin polymer film of high transparency is adhesively bonded to a surface of a rigid frame made from a metal or a plastic resin in a slack-free fashion while the other surface of the frame opposite to the pellicle membrane is coated with a pressure-sensitive adhesive or a double-sided pressure-sensitive adhesive tape is attached thereto so as to facilitate mounting of the frame-supported pellicle on a photomask.

Since it is essential that the frame-supported pellicle is mounted on a photomask in a demountable fashion for replacement of a contaminated pellicle with a fresh one, the adhesive bonding of the pellicle frame to the photomask must be temporary. Various kinds of pressure-sensitive adhesives are proposed and practically used heretofore for the purpose including those based on an acrylic polymer, rubber, polybutene, polyurethane. Needless to say, these adhesives are each of a non-curable type exhibiting stickiness at room temperature so that it is essential that the bottom surface of the pellicle frame coated with such a pressure-sensitive adhesive is strictly prevented from deposition of any dust particles or other contamination until the pellicle is mounted on a photomask. The most conventional means to achieve such temporary protection is to attach a sheet of surface-release paper to the adhesive-coated sticky surface of the pellicle frame and to remove the surface-release paper immediately before mounting of the pellicle on a photomask. The above-mentioned surface-release paper is a sheet of paper or a plastic film coated with a wax-like or silicone-based releasing agent.

EP-A-0 469 928 discloses pressure sensitive tapes including a release agent comprising a curable silicone composition. Said curable silicone composition is capable of adhering firmly to a variety of substrates such as paper, plastic film and metal sheet.

US-A-4 171 397 discloses sheet materials notably pressure sensitive tapes which are provided with composite coatings having desired release values. The release surfaces which present fluorochemical polymer and cured silicone polymer areas, are formed by first applying specific types of fluorochemical polymer and then overcoating with silicone-forming reactants.

US-A-5 073 422 discloses a pressure-sensitive adhesive structure having a release agent layer comprising a cured fluorosilicone composition.

EP-A-0 378 420 discloses a pressure sensitive adhesive provided with a release sheet comprising an organohydrogenpolysiloxane compound and a fluorosilicone polymer.

A serious problem in the above described frame-supported pellicle is that the pressure-sensitive adhesive applied to the bottom surface of the pellicle frame is subject to degradation in the lapse of time by the effect of the ultraviolet light used for the pattern-wise exposure through the photomask so that the adhesive bonding power of the above mentioned conventional pressure-sensitive adhesive is decreased eventually to cause falling of the pellicle from the photomask unless the pellicle is replaced with a fresh one. This problem is particularly serious when the light used for the pattern-wise exposure is an excimer laser beam sometimes necessitating replacement of the pellicle in every several hours during the patterning work.

In compliance with the desire to obtain a pressure-sensitive adhesive having higher resistance against the influence of ultraviolet light than the above named conventional pressure-sensitive adhesives, a proposal has been made for the use of a silicone-based pressure-sensitive adhesive such as those consisting of the mono-, di- and tetrafunctional siloxane units. Although these silicone-based pressure-sensitive adhesives are indeed more resistant against ultraviolet light than the conventional ones, a difficult problem from the standpoint of practical use thereof is that the surface-release paper sheet such as those mentioned above and useful for the conventional pressure-sensitive adhesives can no longer exhibit adequate surface releasability on the sticky surface coated with a silicone-based pressure-sensitive adhesive. Use of a thin film of a fluorocarbon polymer, e.g., "Teflon", has been proposed in place of conventional surface-release paper but the surface-releasability thereof is not sufficiently high so that no practicability is seen in the use thereof even by setting aside the problem of high costs. Alternatively, another proposal has been made for the use of a surface-release paper sheet coated with a releasing agent formulated with a fluorocarbon polymer but such a fluorocarbon-based release paper sheet has a problem of migration of the releasing agent to the sticky surface of the pellicle frame coated with a silicone-based pressure-sensitive adhesive to cause a decrease in the bonding strength of the adhesive.

### SUMMARY OF THE INVENTION

The present invention accordingly has an object to provide an improvement in the method for temporarily protecting the surface of a pellicle frame coated with a silicone-based pressure-sensitive adhesive from eventual contamination and dust particle deposition thereon to be freed from the above described problems and disadvantages in the prior art.

Thus, the present invention provides a method for temporarily protecting a surface of a pellicle frame, to the other surface of which a pellicle membrane is adhesively bonded, coated with a pressure-sensitive adhesive which comprises an organopolysiloxane comprising monofunctional siloxane units represented by the general unit formula R₃SiO_{0.5}, in which R is a monovalent hydrocarbon group, and tetrafunctional siloxane units expressed by the unit formula SiO₂, said method comprising the step of attaching, to the adhesive-coated surface of the pellicle frame, a surface-release sheet having a layer of an organopolysiloxane composition of which the organopolysiloxane has at least one polyfluoroalkyl-containing aliphatic group in a molecule, characterized in that the organopolysiloxane composition for the surface-release sheet comprises a copolymer of a polyfluoroalkyl-containing vinyl or (meth)acrylic monomer and an organosilicon compound having an ethylenically unsaturated group copolymerizable therewith and a hydrolyzable group bonded to the silicon atom in a molecule and a catalytic compound for the condensation reaction of the hydrolyzable groups.

### DETAILED DESCRIPTION OF THE PREFERRED EMBODIMENTS

As is described above, the improvement of the present invention is characterized by the use of a surface-release paper sheet coated with a specific releasing agent which is particularly effective when the pressure-sensitive adhesive, with which the bottom surface of a pellicle frame is coated, is a specific organopolysiloxane-based adhesive.

The frame-supported pellicle *per se* can be a conventional one consisting of a rigid frame made from a metal or alloy such as stainless steel or a plastic resin such as polyethylene and a thin transparent polymeric film as a pellicle membrane adhesively bonded to one surface of the pellicle frame in a slack-free fashion. The polymeric resin from which the pellicle membrane is formed can be any of conventional ones including cellulose derivatives such as nitrocellulose and cellulose acetate and recently developed fluorocarbon polymers such as copolymers of tetrafluoroethylene and vinylidene fluoride, ternary copolymers of tetra-fluoroethylene, hexafluoropropylene and vinylidene fluoride. The thickness of the pellicle membrane can also be conventional.

In the frame-supported pellicle to which the present invention is applicable, a surface of the pellicle frame, which is opposite to the surface to which the pellicle membrane is adhesively bonded, is coated with a specific organopolysiloxane-based pressure-sensitive adhesive. The organopolysiloxane-based pressure-sensitive adhesive of a particularly preferable type comprises, as the principal ingredient, an organopolysiloxane consisting of monofunctional siloxane units represented by the general unit formula R₃SiO_{0.5}, in which R is a monovalent hydrocarbon group, tetrafunctional siloxane units expressed by the unit formula SiO₂ and, optionally, difunctional siloxane units represented by the general unit formula R₂SiO, in which R has the same meaning as defined above. The monovalent hydrocarbon group denoted by R in the above given unit formulas is selected from the class consisting of alkyl groups such as methyl, ethyl, propyl and butyl groups, alkenyl groups such as vinyl and allyl groups and aryl groups such as phenyl and tolyl groups as well as those substituted hydrocarbon groups obtained by replacing a part or all of the hydrogen atoms in the above named hydrocarbon groups with chlorine atoms, cyano groups. The pressure-sensitive adhesives of this type are well known in the art of silicones and products of several grades are available on the market including those sold by Shin-Etsu Chemical Co. under the tradenames of KR-101-10, KR-120, KR-130 and X-40-3068. As is stated before, these organopolysiloxane-based pressure-sensitive adhesives are very stable against ultraviolet irradiation but are not under practical use as an adhesive coating agent on the bottom surface of pellicle frames because conventional surface-release paper sheets cannot be used for temporary protection of the adhesive-coated surface. The thickness of the adhesive coating layer on the bottom surface of a pellicle frame is not particularly limitative and can be conventional.

The bottom surface of a pellicle frame coated with the above described specific pressure-sensitive adhesive must be temporarily protected by attaching a sheet of surface-release paper thereto since otherwise the surface retaining stickiness is subject to eventual contamination or dust deposition to become unsuitable for mounting on a photomask. As mentioned above, however, conventional surface-release sheets prepared by using a wax- or silicone-based releasing agent cannot be used in this case since no releasability can be exhibited with such a surface-release paper sheet on the surface coated with the above described specific pressure-sensitive adhesive. According to the improvement provided by the invention, the releasing agent with which the surface-release paper is coated is a specific fluorine-containing organopolysiloxane composition which can be cured into a cured coating film exhibiting excellent surface releasability even on a sticky surface coated with the above described organopolysiloxane-based pressure-sensitive adhesive and is free from the problem of migration to the layer of the pressure-sensitive adhesive

The releasing agent from which the surface-release paper is prepared is a composition comprising a copolymer of a polyfluoroalkyl-containing vinyl or (meth)acrylic monomer and an organosilicon compound having an ethylenically unsaturated group copolymerizable with the former monomer and a hydrolyzable group bonded to the silicon atom in a molecule and a catalytic compound for the condensation reaction of the hydrolyzable groups.

The above mentioned polyfluoroalkyl-containing vinyl or (meth)acrylic monomer, i.e. a vinyl or (meth)acrylic monomer having an alkyl group, such as propyl, butyl and octyl groups, substituted with at least two fluorine atoms for the hydrogen atoms, is exemplified by those expressed by the following structural formulas, in which Me denotes a methyl group:

CH₂=CH-CO-O-CH₂CF₃;

CH₂=CMe-CO-O-CH₂CF₃;

CH₂=CH-CO-O-CH₂CF₂CF₂H;

CH₂=CMe-CO-O-CH(CF₃)₂;

CH₂=CH-CO-O-CHMeC₃F₇;

CH₂=CH-CO-O-CH₂C₄F₉;

CH₂=CMe-CO-O-CH₂C₄F₉;

CH₂=CH-CO-O-CH₂(CF₂)₄H;

CH₂=CMe-CO-O-CH₂C₆F₁₃;

CH₂=CMe-CO-O-(CH₂)₂C₈F₁₇;

CH₂=CH-CO-O-(CH₂)₂C₈F₁₇;

CH₂=CH-O-(CH₂)₂C₈F₁₇;

CH₂=CH-CO-O-(CH₂)₂OCH₂CF₃; and

CH₂=CH-CO-O-(CH₂)₂OCH₂C₄F₉.

The organosilicon compound having an ethylenically unsaturated group to be copolymerized with the above described fluorine-containing monomer should have at least one hydrolyzable group bonded to the silicon atom in a molecule. The hydrolyzable group is exemplified by acyloxy groups such as acetoxy, octanoyloxy and benzoyloxy groups, ketoxime groups such as dimethylketoxime, methylethylketoxime and diethylketoxime groups, alkoxy groups such as methoxy, ethoxy and propoxy groups, alkenyloxy groups such as isopropenyloxy and 1-ethyl-2-mehyl vinyloxy groups, substituted amino groups such as dimethylamino, diethylamino, butylamino and cyclohexylamino groups, substituted aminoxy groups such as dimethylaminoxy and diethylaminoxy groups, amido groups such as N-methyl acetamido, N-ethyl acetamido and N-methyl benzamido groups. It is important in the selection of the hydrolyzable group that the hydrolysis product formed therefrom can be easily and rapidly dissipated out of the composition during or after curing.

Examples of the above mentioned organosilicon compound having an ethylenically unsaturated group include those expressed by the following formulas, in which the symbols Me, Et and Ph each denote a methyl, an ethyl and a phenyl group, respectively:

CH₂=CH-CO-O-(CH₂)₃-Si(OMe)₃;

CH₂=CH-CO-O-(CH₂)₃-Si(OEt)₃;

CH₂=CMe-CO-O-(CH₂)₃-Si(OMe)₃;

CH₂=CMe-CO-O-(CH₂)₃-Si(OEt)₃;

CH₂=CH-CO-O-(CH₂)₃-SiMe(OEt)₂;

CH₂=CMe-CO-O-(CH₂)₃-SiEt(OMe)₂;

CH₂=CMe-CO-O-(CH₂)₃-SiMe₂(OEt);

CH₂=CMe-CO-O-(CH₂)₃-SiMe₂(OMe);

CH₂=CH-CO-O-(CH₂)₃-Si(O-COMe)₃;

CH₂=CMe-CO-O-(CH₂)₃-SiEt(O-COMe)₂;

CH₂=CMe-CO-O-(CH₂)₃-SiMe(NMe-COMe)₂;

CH₂=CH-CO-O-(CH₂)₃-SiMe(O-NMeEt)₂;

CH₂=CMe-CO-O-(CH₂)₃-SiPh(O-NMeEt)₂;

CH₂=CHSi(O-N=CMeEt)₃;

CH₂=CHSi(O-Me)₃;

CH₂=CHSi(O-Et)₃;

CH₂=CHSiMe(O-Me)₂;

CH₂=CHSi(O-COMe)₃;

CH₂=CHSiEt(O-COMe)₂;

CH₂=CHSiMe₂(O-Et); and

CH₂=CHSiMe(O-NMeEt)₂.

These compounds can be used either as such or as a partial hydrolysis product thereof. It is of course optional that these compounds are used as a combination of two kinds or more according to need.

It is preferable that the copolymer of these two types of monomers is constituted from the moieties of the polyfluoroalkyl vinyl monomer and the organosilicon vinyl monomer having a hydrolyzable group in a weight ratio in the range from 50:50 to 98:2 or, more preferably, from 70:30 to 95:5. When the weight fraction of the moiety of the former monomer is too small, no sufficiently high surface-releasing effect can be obtained on the cured film of the copolymer to the silicone-based pressure-sensitive adhesive along with some brittleness of the cured film. When the weight fraction of the moiety of the former monomer is too large, on the other hand, the releasing agent comprising the copolymer is poorly curable and the cured film of the releasing agent cannot exhibit high adhesive bonding strength to the substrate sheet.

The copolymer can be prepared by a known polymerization method such as solution polymerization of a mixture of the monomers by using a radical polymerization initiator. Suitable polymerization initiator includes azobisisobutyronitrile, di-tert-butyl peroxide, dibenzoyl peroxide, tert-butyl perbenzoate, methyl ethyl ketone peroxide. The copolymerization reaction is usually carried out in an organic solvent by dissolving the monomers and the polymerization initiator therein. Suitable organic solvents include fluorocarbon solvents, e.g., m-xylene hexafluoride, acetate ester solvents, e.g., ethyl acetate, and ketone solvents, e.g., methyl ethyl ketone. The copolymer obtained by the copolymerization can be advantageously stored with stability in the form of a solution as obtained without removing the organic solvent.

It is optional that the releasing agent is admixed, with an object to further improve the strength of the cured film thereof and adhesion of the cured film to the substrate, with a methacrylate ester such as methyl methacrylate, ethyl methacrylate, n-butyl methacrylate, tert-butyl methacrylate, 2-ethylhexyl methacrylate, organosilicon-containing methacrylate such as 3-methacryloxypropyl trimethoxy silane or an aromatic vinyl compound such as styrene, vinyl toluene in a small amount in addition to the copolymer. It is also optional that the releasing agent containing the copolymer is further admixed with a titanate ester compound such as tetrabutoxy titanium or an organotin compound such as dibutyltin diacetate and dioctyltin diacetate as a curing accelerator. Other optional additives to the releasing agent include reinforcing and non-reinforcing inorganic fillers such as finely divided silica powders, talc, clay, diatomaceous earth and carbon black, plasticizers, coloring agents, lubricants, adhesion-improvers.

The substrate material of the surface-release sheet to be coated with the above described releasing agent is not particularly limitative including glassine paper, woodfree paper before a filling treatment, polyethylene film-laminated paper and films of a polymeric resin such as polyester, polypropylene, polyimide, polyethylene. The coating work of these substrates with the releasing agent can be performed by a conventional coating method such as roller coating, spray coating, dip coating. The amount of coating on the substrate with the releasing agent is usually in the range from 0.05 to 5 g/m² or, preferably, from 0.3 to 1.0 g/m² after drying by removing the solvent. The surface-release sheet after coating of a substrate with the releasing agent is preferably subjected to a heat treatment at a temperature of 100 to 200 °C for 10 to 60 seconds so as to accelerate curing of the releasing composition.

In the following, the improvement obtained according to the present invention is described in more detail by way of examples and comparative examples, in which the term of "parts" always refers to "parts by weight".

### Preparation of pressure-sensitive adhesive A

A partial co-condensation product was prepared from 50 parts of a methylpolysiloxane having a branched molecular structure consisting of the monofunctional siloxane units of the unit formula (CH₃)₃SiO_{0.5} and tetrafunctional siloxane units of the unit formula SiO₂ in a molar ratio of 1:2, of which a 50% by weight toluene solution had a viscosity of 55 centipoise at 25 °C, and 50 parts of a dimethylpolysiloxane terminated at each molecular chain end with a silanolic hydroxy group, of which the average number of the dimethylsiloxane units in a molecule was about 9000 on an average. The thus prepared toluene solution had a viscosity of 80,000 centipoise at 25 °C.

The toluene solution was admixed with 0.5% by weight of benzoyl peroxide based on the non-volatile matter in the solution to give a curable pressure-sensitive adhesive, referred to as the adhesive A hereinbelow.

### Preparation of surface-release sheet I.

A solution containing 50% by weight of a non-volatile matter was prepared by dissolving a copolymer prepared by the copolymerization of a 7:3 by weight mixture of a first monomer, which was 2-(perfluorooctyl)ethyl methacrylate expressed by the structural formula CH₂=CCH₃-CO-O-C₂H₄-C₈F₁₇, and a second monomer, which was vinyl triethoxy silane expressed by the structural formula CH₂=CHSi(OC₂H₅)₃, in a fluorocarbon solvent (Daiflon S2-T, a product by Daikin Co.). The solution had a viscosity of 20 centipoise at 25 °C.

The solution was admixed with 3% by weight of a vinyl dibutyltin diacetate based on the non-volatile matter in the solution to give a curable releasing agent. A polyester film having a thickness of 38 µm was coated with the thus prepared solution and subjected to a heat treatment at 130 °C for 2 minutes so that a film of the releasing agent having a thickness of 2.0 µm was formed on the polyester film to give a surface-release sheet, referred to as the release sheet I hereinbelow.

### Examples and Comparative Examples.

A transparent pellicle film of an amorphous fluorine-containing polymer was adhesively bonded in a slack-free fashion to the surface of a square pellicle frame of surface-anodized aluminum having outer dimensions of 110 mm a side, frame width of 2 mm and thickness of 5 mm. The other surface of the pellicle frame was coated with the adhesive A followed by a heat treatment at 120 °C for 15 minutes to dissipate the solvent so that a pressure-sensitive adhesive layer having a thickness of 0.5 mm was formed on the bottom surface of the pellicle frame.

The release sheet I cut in a square form of 115 mm by 115 mm wide was applied and bonded to the thus adhesive-coated bottom surface of the pellicle fame and kept standing as such at room temperature for 1 month. Thereafter, the release sheet was removed from the pellicle frame to find good peelability with no noticeable increase in the resistance against peeling.

With an object to examine adhesiveness retention of the pressure-sensitive adhesive layer after removal of the release sheet, which might be decreased by the migration of the releasing agent to the adhesive layer, the pellicle after removal of the release sheet was put on a fused quartz glass plate having a thickness of 2.3 mm and gently pressed down by hand. The thus prepared assembly of the quartz glass plate and pellicle was held upside down with the glass plate facing upwardly for 30 days at room temperature not to find falling of the pellicle from the glass plate so that it was concluded that bonding of the release sheet had no adverse influence on the adhesiveness of the pressure-sensitive adhesive layer.

Further, the pressure-sensitive adhesive layer on the bottom surface of the pellicle frame was irradiated with ultraviolet light of 254 nm wavelength emitted from a low-pressure mercury lamp in an intensity of 20 mW/cm² to find that the length of time before disappearance of tackiness on the surface of the adhesive layer was 50 hours.

Comparative experiments were undertaken each in about the same manner as in the Examples excepting replacement of the release sheets I with another release sheet prepared by using a commercially available silicone-based releasing agent (KS 778, a product by Shin-Etsu Chemical Co.). The results of the testing were that certain difficulties were encountered in the peeling of the release sheet from the surface of the adhesive layer. For further comparison, another experiment was undertaken in the same manner as above except that the test was for the combination of a commercially available acrylic resin-based pressure sensitive adhesive (BPS 8170, a product by Toyo Ink Manufacturing Co.) and the above mentioned KS 778 as the release agent. The results of testing were that, although no problems were noted in the peelability of the release sheet and the adhesiveness retention on the surface of the adhesive layer after removal of the release sheet, the pressure-sensitive adhesive layer was poorly resistant against ultraviolet irradiation to lose tackiness already after 1 hour of irradiation.

## Claims

1. Method for temporarily protecting a surface of a pellicle frame, to the other surface of which a pellicle membrane is adhesively bonded, coated with a pressure-sensitive adhesive which comprises an organopolysiloxane comprising monofunctional siloxane units represented by the general unit formula R₃SiO_{0.5}, in which R is a monovalent hydrocarbon group, and tetrafunctional siloxane units expressed by the unit formula SiO₂, said method comprising the step of attaching, to the adhesive-coated surface of the pellicle frame, a surface-release sheet having a layer of an organopolysiloxane composition of which the organopolysiloxane has at least one polyfluoroalkyl-containing aliphatic group in a molecule, characterized in that the organopolysiloxane composition for the surface-release sheet comprises a copolymer of a polyfluoroalkyl-containing vinyl or (meth)acrylic monomer and an organosilicon compound having an ethylenically unsaturated group copolymerizable therewith and a hydrolyzable group bonded to the silicon atom in a molecule and a catalytic compound for the condensation reaction of the hydrolyzable groups.

2. Method as claimed in claim 1 in which the polyfluroroalkyl-containing vinyl or (meth)acrylic monomer is selected from the group consisting of the compounds expressed by the formulas:
CH₂ = CH-CO-O- CH₂CF₃ ;
CH₂ = CMₑ-CO-O- CH₂CF₃ ;
CH₂ = CH-CO-O- CH₂CF₂CF₂H ;
CH₂ = CMe-CO-O-CH(CF₃)₂ ;
CH₂ = CH-CO-O-CHMeC₃F₇ ;
CH₂ = CH-CO-O-CH₂C₄F₉ ;
CH₂ = CM_{E}-CO-O-CH₂C₄F₉ ;
CH₂ = CH-CO-O- CH₂(CF₂)₄H;
CH₂ =CMₑ-CO-O-CH₂C₆F₁₃ ;
CH₂ = CMₑ-CO-O-(CH₂)₂C₈F₁₇ ;
CH₂ =CH-CO-O-(CH₂)₂C₈F₁₇ ;
CH₂ = CH-O-(CH₂)₂C₈F₁₇ .
CH₂ = CH-CO-O-( CH₂)₂OCH₂CF₃ ; and
CH₂ = CH-CO-O-(CH₂)₂OCH₂C₄F₉ ;
in which Me is a methyl group.

## Patentansprüche

1. Verfahren zum temporären Schutz einer mit einem drucksensitiven Klebstoff beschichteten Oberfläche eines Filmrahmens, auf dessen andere Oberfläche eine Filmmembran geklebt ist, wobei der Klebstoff ein Organopolysiloxan aufweist, das monofunktionelle Siloxaneinheiten der allgemeinen Formel R₃SiO_{0.5}, worin R eine monovalente Kohlenwasserstoffgruppe bedeutet, und tetrafunktionelle Siloxaneinheiten der Formel SiO₂ aufweist, und wobei bei diesem Verfahren auf die mit dem Klebstoff beschichtete Oberfläche des Filmrahmens ein oberflächenablösbares Blatt mit einer Schicht aus einer Organopolysiloxanzusammensetzung, deren Organopolysiloxan mindestens eine perfluoralkylhaltige aliphatische Gruppe in einem Molekül aufweist, aufgebracht wird, dadurch gekennzeichnet, daß die Organopolysiloxanzusammensetzung für das oberflächenablösbare Blatt ein Copolymer aus einem perfluoralkylhaltigen Vinyl- oder (Meth)acrylsäure-Monomer und eine Organosiliciumverbindung mit einer ethylenisch ungesättigten, damit copolymerisierbaren Gruppe und einer an das Siliciumatom gebundenen hydrolysierbaren Gruppe in einem Molekül und eine katalytische Verbindung für die Kondensationsreaktion der hydrolysierbaren Gruppen aufweist.

2. Verfahren nach Anspruch 1, bei dem das polyfluoralkylhaltige Vinyl- oder (Meth)acrylsäure-Monomer ausgewählt ist aus der Gruppe bestehend aus den Verbindungen der folgenden Formeln:
CH₂ = CH-CO-O-CH₂CF₃;
CH₂ = CMe-CO-O-CH₂CF₃;
CH₂ = CH-CO-O-CH₂CF₂CF₂H;
CH₂ = CMe-CO-O-CH(CF₃)₂;
CH₂ = CH-CO-O-CHMeC₃F₇;
CH₂ = CH-CO-O-CH₂C₄F₉;
CH₂ = CMe-CO-O-CH₂C₄F₉;
CH₂ = CH-CO-O-CH₂(CF₂)₄H;
CH₂ = CMe-CO-O-CH₂C₆F₁₃;
CH₂ = CMe-CO-O-(CH₂)₂C₈F₁₇;
CH₂ = CH-CO-O-(CH₂)₂C₈F₁₇;
CH₂ = CH-O-(CH₂)₂C₈F₁₇;
CH₂ = CH-CO-O-(CH₂)₂OCH₂CF₃: und
CH₂ = CH-CO-O-(CH₂)₂OCH₂C₄F₉;
worin Me für eine Methylgruppe steht.

## Revendications

1. Procédé de protection temporaire d'une surface d'un châssis d'opercule pelliculaire à l'autre surface duquel une membrane d'opercule pelliculaire est liée de façon adhésive, recouverte d'un adhésif sensible à l'effet de la pression, lequel comporte un organopolysiloxane comportant des unités siloxanes monofonctionnelles représentées par la formule unitaire générale R₃SiO_{0.5}, dans laquelle R représente un groupe hydrocarbure monovalent, et des unités siloxanes tétrafonctionnelles exprimées par la formule unitaire SiO₂, ledit précédé comportant l'étape consistant à fixer, à la surface recouverte d'adhésif du châssis de l'opercule pelliculaire, une feuille à libération de surface comportant une couche d'une composition d'organopolysiloxane dont l'organopolysiloxane comporte, au moins, un groupe aliphatique contenant un polyfluoroalkyle dans une molécule, caractérisé en ce que la composition d'organopolysiloxane destiné à la feuille à libération de surface comprend un copolymère d'un vinyle contenant un polyfluoroalkyle ou un monomère (méth)acrylique et un composé d'organosilicium comportant un groupe insaturé éthyléniquement copolymérisable avec eux et un groupe hydrolysable lié à l'atome de silicium dans une molécule et un composé catalyseur en vue de la réaction de condensation des groupes hydrolysables.

2. Procédé selon la revendication 1, dans lequel le vinyle contenant un polyfluoroalkyle ou le monomère (méth)acrylique est sélectionné à partir du groupe constitué des composés exprimés par les formules:
CH₂ = CH-CO-O- CH₂CF₃ ;
CH₂ = CMₑ-CO-O- CH₂CF₃ ;
CH₂ = CH-CO-O- CH₂CF₂CF₂H ;
CH₂ = CMe-CO-O-CH(CF₃)₂;
CH₂ = CH-CO-O-CHMeC₃F₇;
CH₂ = CH-CO-O-CH₂C₄F₉;
CH₂ = CM_{E}-CO-O-CH₂C₄F₉;
CH₂ = CH-CO-O-CH₂(CF₂)₄H;
CH₂ =CMₑ-CO-O-CH₂C₆F₁₃;
CH₂ = CMₑ-CO-O-(CH₂)₂C₈F₁₇;
CH₂ =CH-CO-O-(CH₂)₂C₈F₁₇;
CH₂ = CH-O-(CH₂)₂C₈F₁₇.
CH₂ = CH-CO-O-(CH₂)₂OCH₂CF₃; et
CH₂ = CH-CO-O-(CH₂)₂OCH₂C₄F₉;
dans lesquelles Me représente un groupe méthyle.
